# EUROPÄISCHE PATENTANMELDUNG

(11) **EP 0 944 298 A2**
(43) Veröffentlichungstag der Anmeldung: **22.09.1999**
(21) Anmeldenummer: 99104256.5
(22) Anmeldetag: 03.03.1999
(51) Int. Cl.: H05K 7/20, B60R 16/02

(54) **Gehäuse zur Aufnahme von elektrischen und/oder elektronischen Bauteilen**

(30) Priorität: 19.03.1998 DE 19812042
(71) Anmelder: Harting KGaA, 32325 Espelkamp (DE)
(72) Erfinder: Harting, Dietmar, 32339 Espelkamp (DE); Müller, Wulf, Dipl.-Ing., 42283 Wuppertal (DE); Ciezarek, Marek, Dipl.-Ing., 32312 Lübbecke (DE)

(57) **Zusammenfassung**

Ein Gehäuse (1) zur Aufnahme von elektrischen und/oder elektronischen, von einem Kühlmedium (10) umgebenen Bauteilen (6), bestehend aus einem Seitenwandteil (2) und einem oberseitigen und einem unterseitigen Abschlußwandteil (3;4) wird so ausgebildet, daß der Seitenwandteil (2) und/oder ein Abschlußwandteil (3;4) aus elektrisch isolierendem, gießfähigem Material besteht und in dieses eingegossene elektrische Verbindungsteile (50) umfaßt, wobei der Seitenwandteil (2) und die Abschlußwandteile (3;4) gemeinsam einen mit einem Kühlmittel (10) zur Siedebadkühlung der elektrischen und/oder elektronischen Bauteile befüllbaren Aufnahmeraum druckdicht umschließen.

## Beschreibung

Die Erfindung betrifft ein Gehäuse zur Aufnahme von elektrischen oder elektronischen Bauteilen nach dem Oberbegriff des Anspruchs 1.

Derartige Gehäuse finden insbesondere Verwendung, um leistungselektronische Bauteile aufzunehmen, die während des Betriebes eine hohe Wärmeabgabe zeigen und daher von einem Kühlmedium umgeben sind. Die in einer solchen Leistungselektronik eingesetzten Halbleiter sind bis zu einer Maximaltemperatur belastbar, deren Unterschreiten durch das Kühlmedium jederzeit sowohl während des Betriebes als auch bei Wärmeeinwirkung von außen sichergestellt sein muß. Typischerweise liegt diese Maximaltemperatur bei etwa 150°C.

Insbesondere bei Einsatz eines derartigen Gehäuses in mobilen Einheiten mit wechselnden Betriebszuständen, wie etwa in Kraftfahrzeugen, treten erhebliche Temperaturschwankungen auf, trotz denen die Funktionalität des Gehäuses und des darin enthaltenen Kühlmittels über ein Temperaturintervall von ca. +150°C bis zu einigen -10°C sicherzustellen ist. Dabei ist auch zu berücksichtigen, daß der Kühlmediumdruck sich mit der Temperatur ändert.

Zudem sind für die Funktion der elektronischen Bauteile hohe Stabilitätsanforderungen und eine Stoß- und Vibrationsentkopplung der aufgenommenen Bauteile von der Umgebung sicherzustellen.

Der Erfindung liegt das Problem zugrunde, ein gattungsgemäßes Gehäuse zu schaffen, das über einen weiten Temperaturbereich die Funktion der aufgenommenen Bauteile sicherstellt.

Die Erfindung löst dieses Problem durch ein Gehäuse mit den Merkmalen des Anspruches 1. Hinsichtlich weiterer vorteilhafter Ausgestaltungen wird auf die Ansprüche 2 bis 21 verwiesen.

Das erfindungsgemäße Gehäuse kann unmittelbar mit Kühlmittel befüllt werden, und die Bauteile können in das Kühlmittel eingehängt sein. Durch die Druckdichtigkeit der Verbindung des oder der Abschlußwandteile zu dem Seitenwandteil und durch die in Wandungsteile integrierte, abgedichtete Aufnahme von elektrischen Verbindungsteilen ist über einen großen Druckbereich des Kühlmediums - und damit über einen weiten Temperaturbereich - sichergestellt, daß kein Kühlmedium unkontrolliert entweichen kann und somit die Kühlfunktion des Kühlmediums für die Bauteile nicht beeinträchtigt ist. Zur verbesserten Abdichtung zwischen den eingegossen elektrischen Verbindungsteilen und dem Seitenwandteil bzw. Abschlußwandteil, der die Verbindungsteile aufnimmt, kann eine zusätzlich Vergußmasse zwischen diesen Teilen angeordnet sein, die aus dauerelastischem, an Metall und Kunststoff haftendem, weichem Material gebildet ist, so daß auch bei großen Temperaturschwankungen die unterschiedlichen Temperaturkoeffizienten der Materialien nicht zu einer Undichtigkeit im Spaltbereich zwischen den unterschiedlichen Materialien führen.

In vorteilhafter Ausgestaltung ist der Seitenwandbereich als umlaufender Rahmen ausgebildet, der beidseits von Deckelteilen eingespannt ist. Ein derartiger Rahmen ist während der Montage und während der Herstellung von beiden Seiten zugänglich, was bei eingegossenen elektrischen Kontakten für die Entformung vorteilhaft ist. Zudem können beide Deckelteile einen elastisch verformbaren Bereich zur Anpassung an eine Druckdifferenz zwischen dem innerhalb und außerhalb des Gehäuses herrschenden Druck aufweisen. Bei Temperatur- und Druckanstieg im Gehäuse findet durch eine Auswölbung dieser Bereiche eine Volumenvergrößerung statt, so daß der Pegel des Kühlmediums in seinem Anstieg nach oben gebremst wird. Umgekehrt ist bei besonders niedrigen Temperaturen eine Einwölbung der verformbaren Bereiche möglich, um das Volumen zu verkleinern. Dadurch verbleiben auch im oberen Gehäusebereich angeordnete Bauteile bei verschiedensten Drücken von Kühlmedium umgeben, der Pegel des Kühlmediums wird weitgehend konstant gehalten. Hierzu tragen auch besonders vorteilhaft Aufnahmetaschen im oberen Bereich des Gehäuses bei, die bei Temperaturanstieg im Kühlmedium und entsprechender Ausdehnung einen Großteil des ansteigenden Kühlmediums aufnehmen, so daß der Pegelanstieg gehemmt ist. Bei zu großem Pegelanstieg würde ansonsten Kühlmedium über eine Ausgleichsleitung aus dem Gehäuse gedrückt werden, so daß die Kühlfunktion nicht hinreichend gewährleistet wäre.

Um eine Kühlung und Rekondensation von verdampftem Kühlmedium zu erreichen, ist im oberen Bereich des Gehäuses eine Gasleitung vorgesehen, die über eine Austrittsöffnung mit einem Kühler verbunden und besonders vorteilhaft so ausgebildet ist, daß die Gasleitung zwei Eintrittsöffnungen in oberen Eckbereichen des Gehäuses aufweist, an die sich Leitungsteile anschließen, die im mittleren Gehäusebereich miteinander in Verbindung stehen, wobei von dem mittleren Bereich ein weiterer Leitungsteil zur Austrittsöffnung abzweigt. Bei Schräglage der mobilen Einheit kann der mittlere obere Gehäusebereich dann von flüssigem Kühlmedium überschwemmt werden, ohne daß dieses aus der Austrittsöffnung das Gehäuse verlassen könnte. Das Gehäuse kann dadurch bis in den oberen Bereich mit Kühlmedium angefüllt sein.

Weitere Vorteile und Einzelheiten ergeben sich aus in der Zeichnung dargestellten Ausführungsbeispielen des Gegenstandes der Erfindung.

In der Zeichnung zeigt:

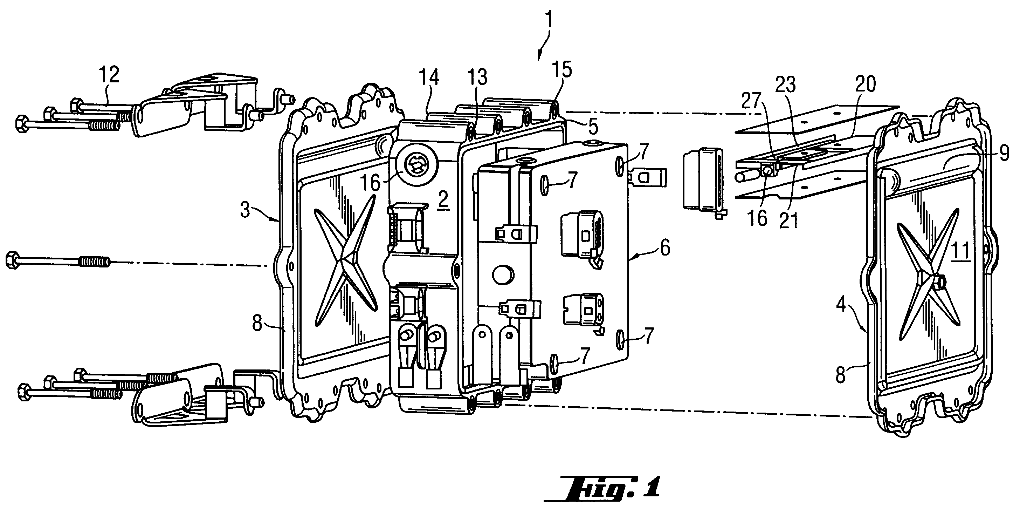

- Fig. 1: eine Explosionsdarstellung eines erfindungsgemäßen Gehäuses,

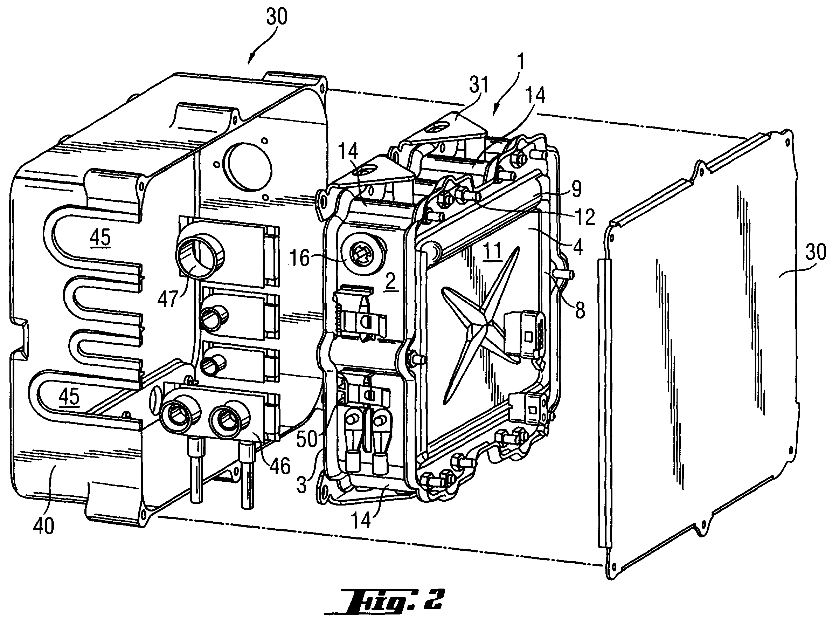

- Fig. 2: das Gehäuse nach Fig. 1 bei Einsatz in einem eine Kapsel bildenden Außengehäuse,
- Fig. 3: das Gehäuse nach Fig. 1 im Längsschnitt bei Überdruck im Gehäuse und hoher Temperatur,

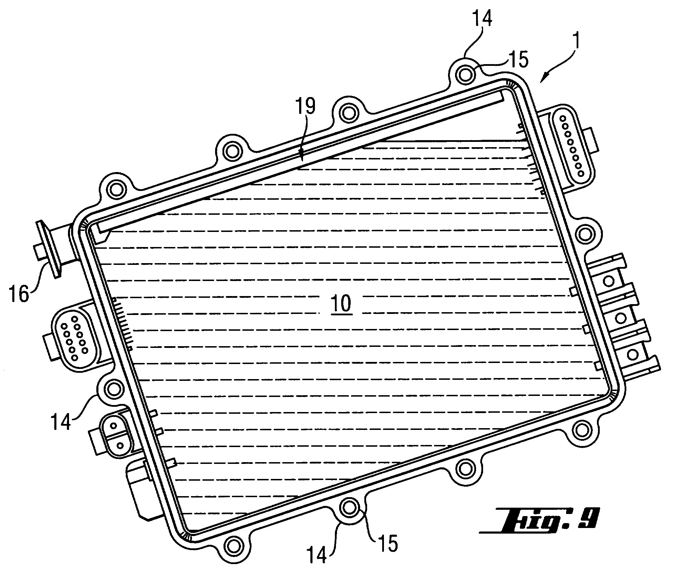

- Fig. 4: eine ähnliche Ansicht wie Fig. 3 bei Normaldruck und Raumtemperatur,
- Fig. 5: eine ähnliche Ansicht wie Fig. 4 bei im Gehäuse herrschenden Unterdruck und niedriger Temperatur,
- Fig. 6: eine ähnliche Ansicht wie Fig. 4 mit einer das Gehäuse umgebenden Wärmeisolierung,
- Fig. 7: eine Detailansicht einer Gasleitung im oberen Bereich des Gehäuses,
- Fig. 8: die Gasleitung nach Fig. 7 in Explosionsdarstellung,
- Fig. 9: das Gehäuse bei extremer Neigung,
- Fig. 10: eine Detailansicht der Gasaustrittöffnung,
- Fig. 11: eine Detailansicht des von den Deckelteilen eingespannten Randbereichs des Rahmens des Gehäuses
- Fig. 12: eine ähnliche Ansicht wie Fig. 11 bei innerhalb des Gehäuses liegendem Spannelement,
- Fig. 13: eine Draufsicht auf das Teil nach Fig. 12,
- Fig. 14: eine ähnliche Ansicht wie Fig. 12 bei mittig in dem Rahmen liegender Verschraubung,
- Fig. 15: eine ähnliche Ansicht wie Fig. 14 in Draufsicht,

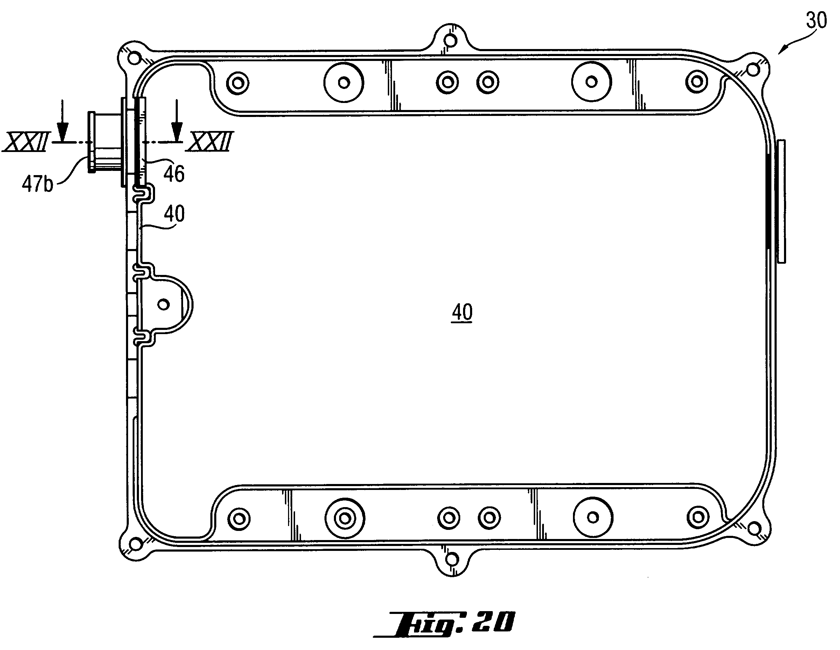

- Fig. 16: eine ähnliche Ansicht wie Fig. 14 bei außerhalb des Gehäuses liegendem Spannelement,

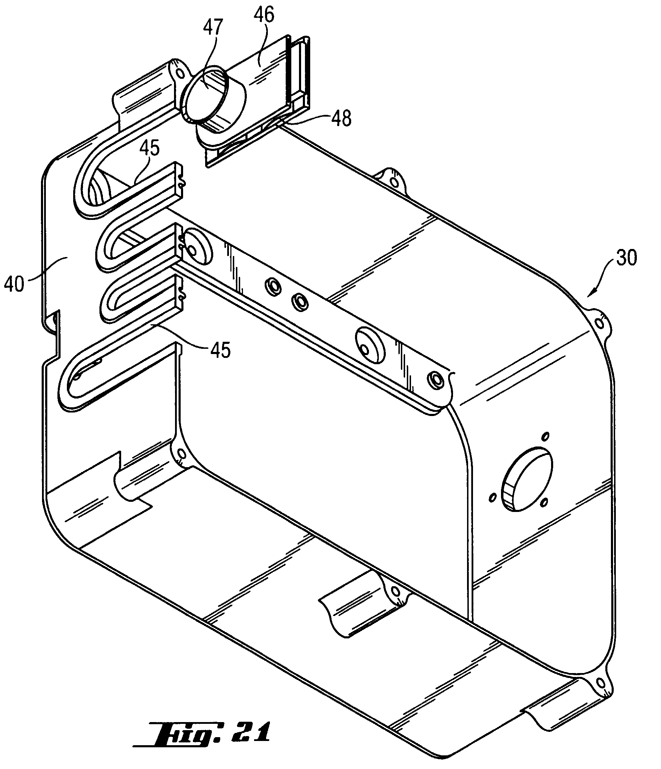

- Fig. 17: eine Draufsicht auf das Teil nach Fig. 16,

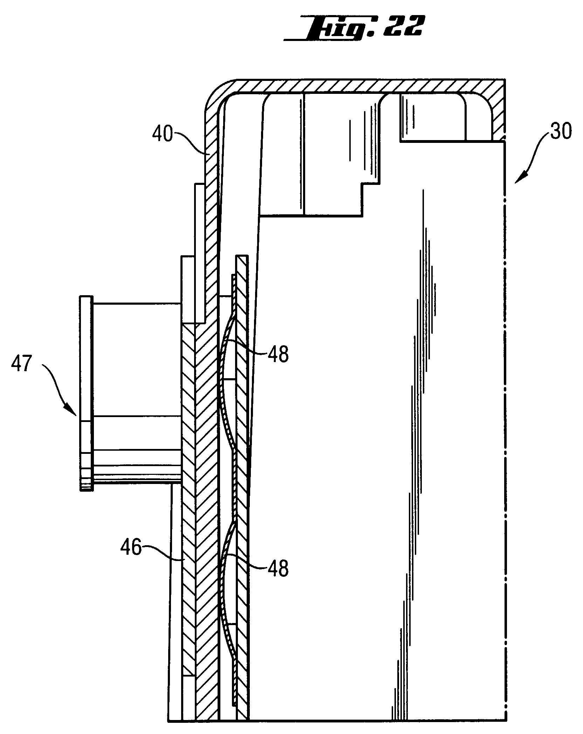

- Fig. 18: eine ähnliche Ansicht wie Fig. 16 mit sich am Deckelrand abstützenden Kunststoffrahmen,
- Fig. 19: verschiedene Dichtungsprinzipien zur druckdichten Verbindung des Rahmens mit den Deckelteilen,
- Fig. 20: das Außengehäuse in Seitenansicht,

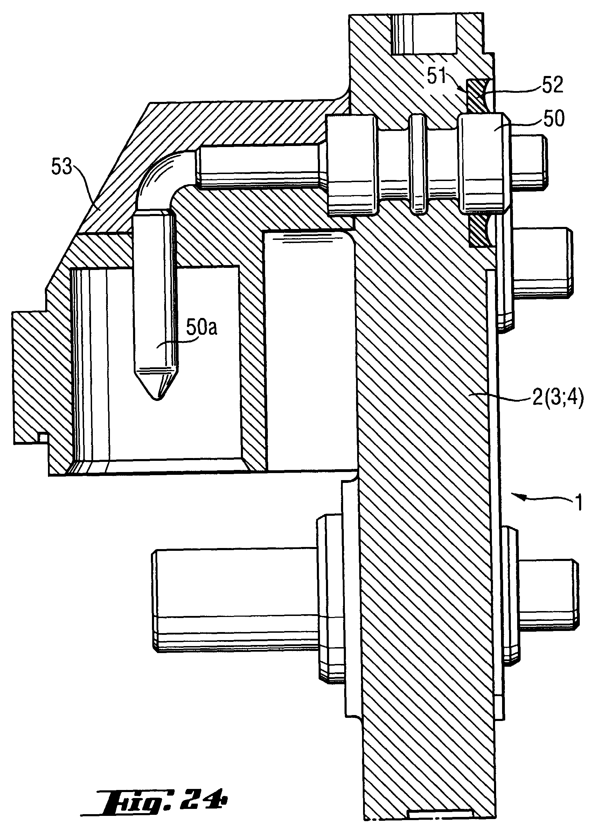

- Fig. 21: das Außengehäuse in geöffneter, perspektivischer Darstellung,

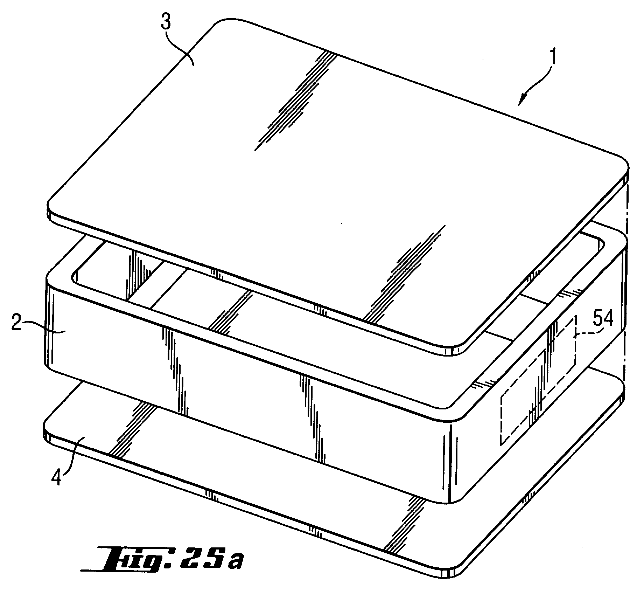

- Fig. 22: einen Schnitt entlang der Linie XXII-XXII in Fig. 20,
- Fig. 23: einen Schnitt durch die Gehäusewandung sowie eine Wandung des Außengehäuses und die Anordnung eines Anschlußkabels,

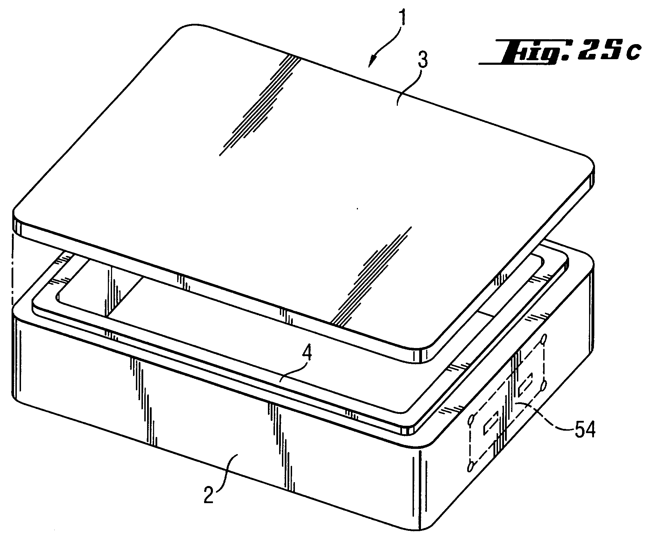

- Fig. 24: eine Detailansicht der Einbettung eines elektrischen Verbindungsteils in einen Abschlußwand- bzw. Seitenwandteil des Gehäuses
- Fig. 25: eine schematische Ansicht dreier verschiedener Gehäusetypen.

In einem Ausführungsbeispiel weist das Gehäuse 1 als Seitenwandungsteil 2 einen umlaufenden Rahmen sowie beidseits des Rahmens 2 angeordnete und als Deckelteile ausgebildete Wandabschlußteile 3,4 auf. Die Dekkelteile 3,4 sind fest auf den Rahmen 2 gespannt, die Verbindung ist druckdicht, wozu eine den Rahmen 2 umlaufende Dichtung 5 auf jeder Seite des Rahmens 2 vorgesehen ist. Es ist auch möglich, daß der Seitenwandungsteil integral mit einem Abschlußwandteil ausgebildet ist und nur das Abschlußwandteil auf der diesem gegenüberliegenden Seite ein separates Deckelteil ausbildet.

In Gebrauchsstellung steht das Gehäuse 1 vertikal aufrecht, so daß die ober- und unterseitigen Wandabschlußteile 3,4 eine senkrechte Lage einnehmen.

In dem Gehäuse 1 ist eine Baugruppe 6 aus elektrischen und/oder elektronischen Bauteilen innerhalb eines Kühlmediums gehalten, eine Abstützung der Baugruppe 6 gegenüber dem Gehäuse kann über Druckpuffer 7 erfolgen.

Die Deckelteile 3,4 sind randseitig mit umlaufenden formsichernden Verstärkungen 8, beispielsweise Sicken, versehen. Diese sind im oberen Bereich des Gehäuses 1 als nach außen hervorstehende Sicken 9 ausgebildet. Diese erfüllen nicht nur eine Formsicherungsfunktion, sondern bilden auch ausgeformte Aufnahmetaschen für Kühlmedium 10 aus. Bei Ansteigen des Drucks und Ausdehnung des von dem Gehäuse 1 umschlossenen Kühlmediums 10 dehnt sich dieses daher nicht alleine nach oben, sondern auch seitwärts in die Aufnahmetaschen 9 aus, so daß der Pegel der Flüssigkeit sich weniger ändert, als wenn die Gehäusewandungen geradlinig nach oben verlaufen würden.

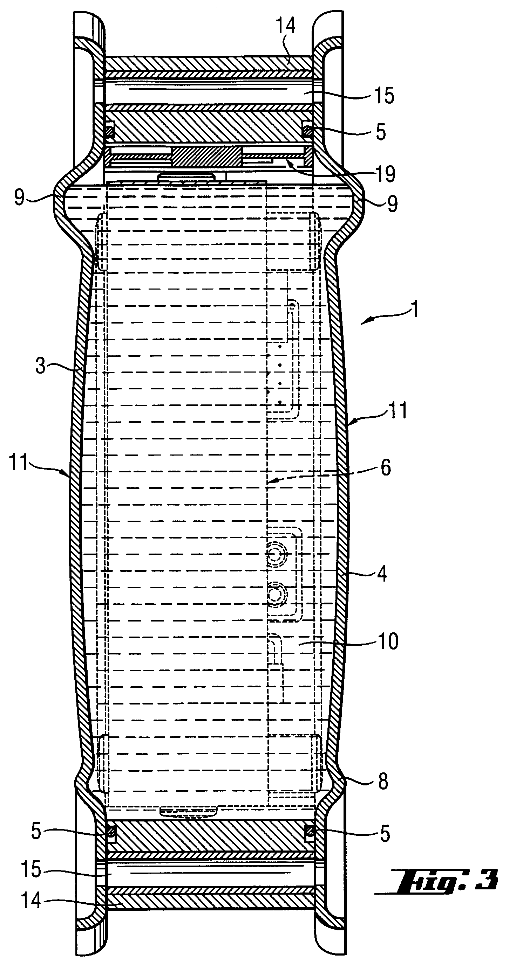

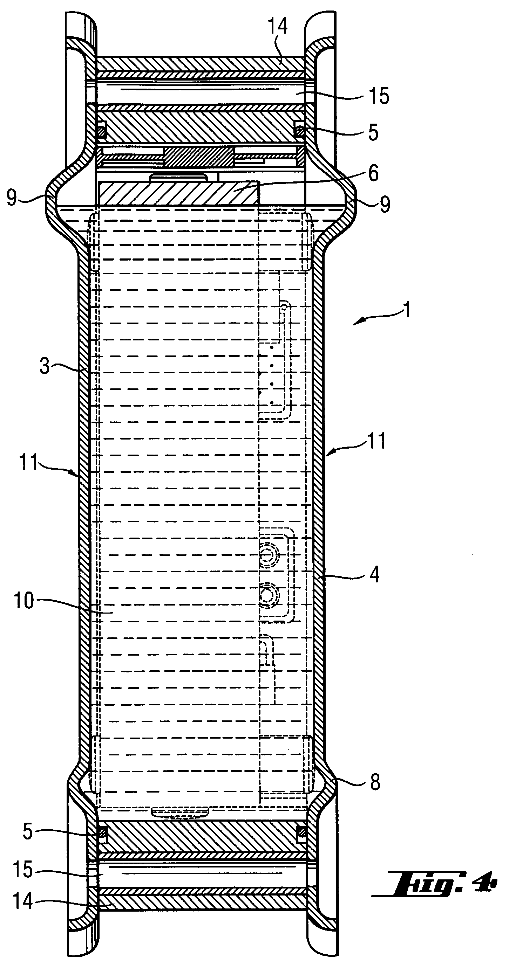

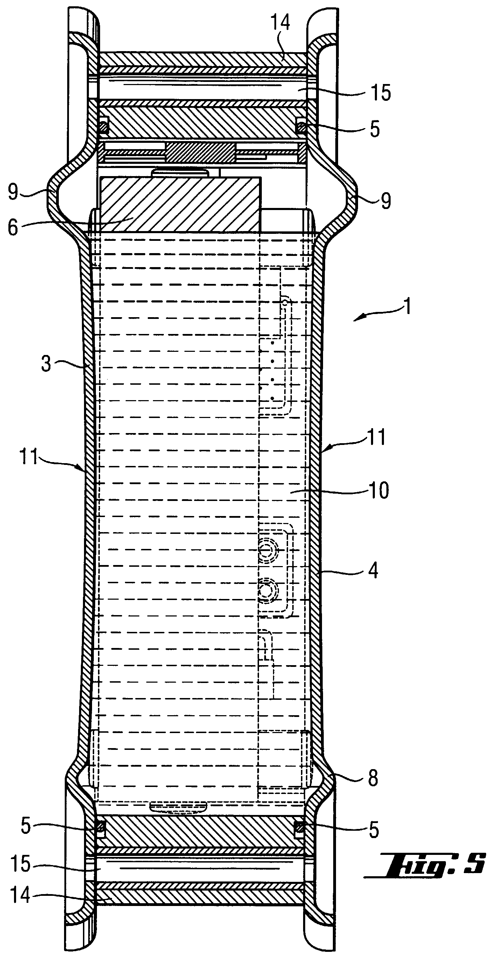

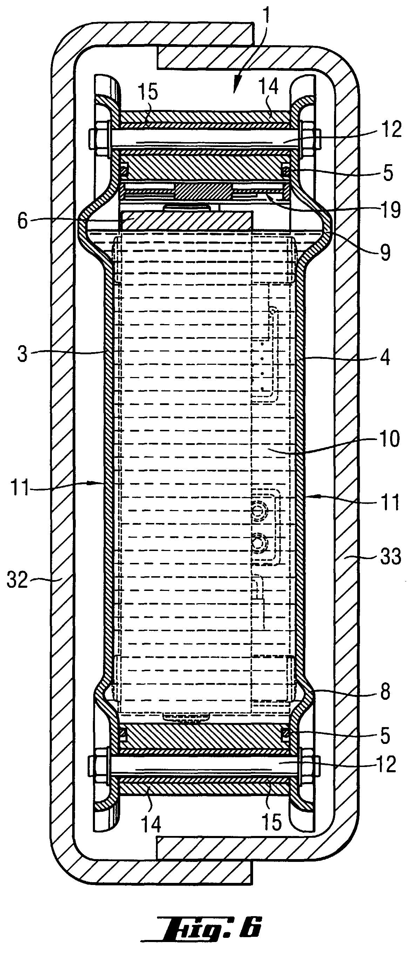

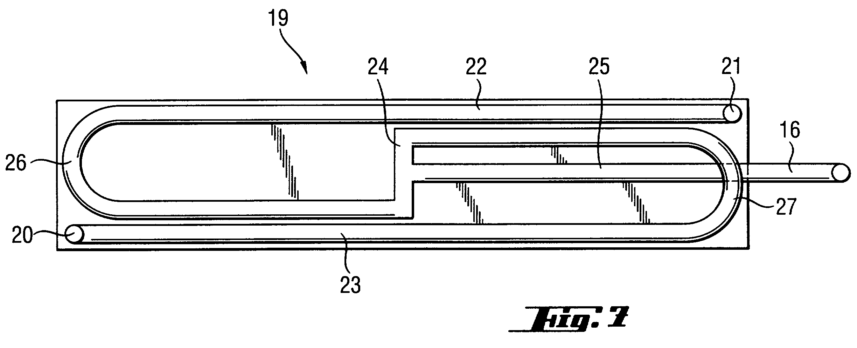

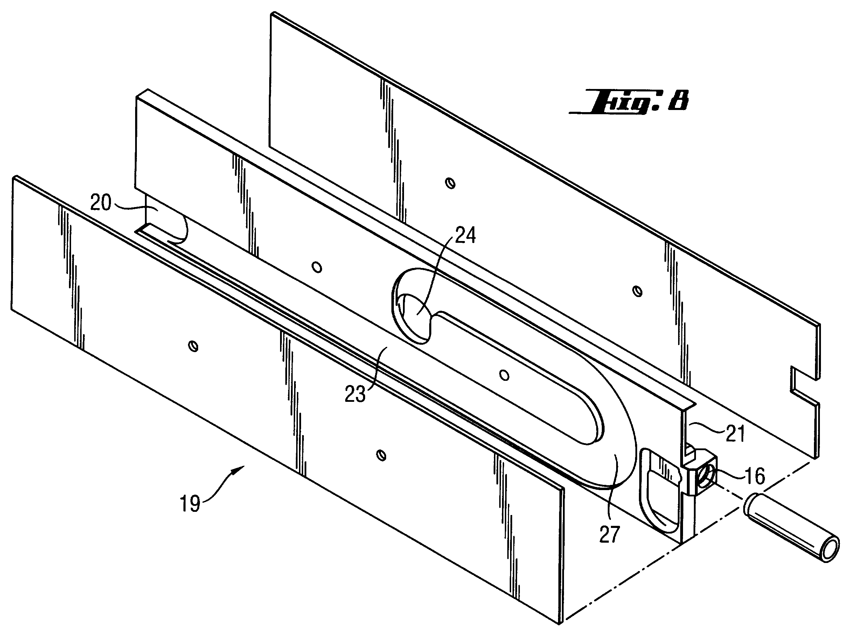

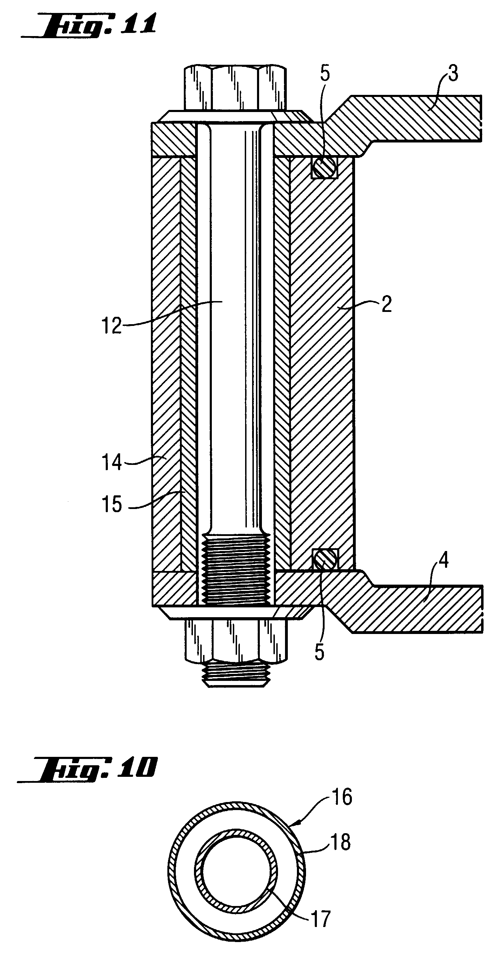

Innerhalb des von den Verstärkungen 8,9 umgebenen mittleren Bereiches 11 ist zumindest ein Deckelteil 3 bzw. 4 elastisch verformbar, so daß bei einem zunehmenden Innendruck der Bereich 11 nach außen hin (Fig. 3) bzw. bei einem sehr geringen Innendruck nach innen gewölbt werden kann (Fig. 5). Im Ausführungsbeispiel sind beide Deckelteile 3,4 verformbar. Dadurch kann ein großer Bereich verschiedener Drücke im Gehäuse 1 auftreten, ohne daß dessen Funktion beeinträchtigt wäre.

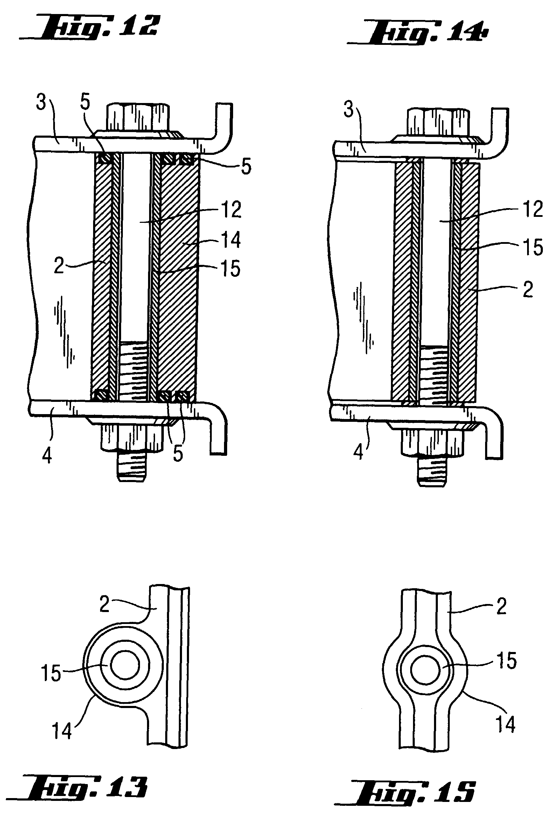

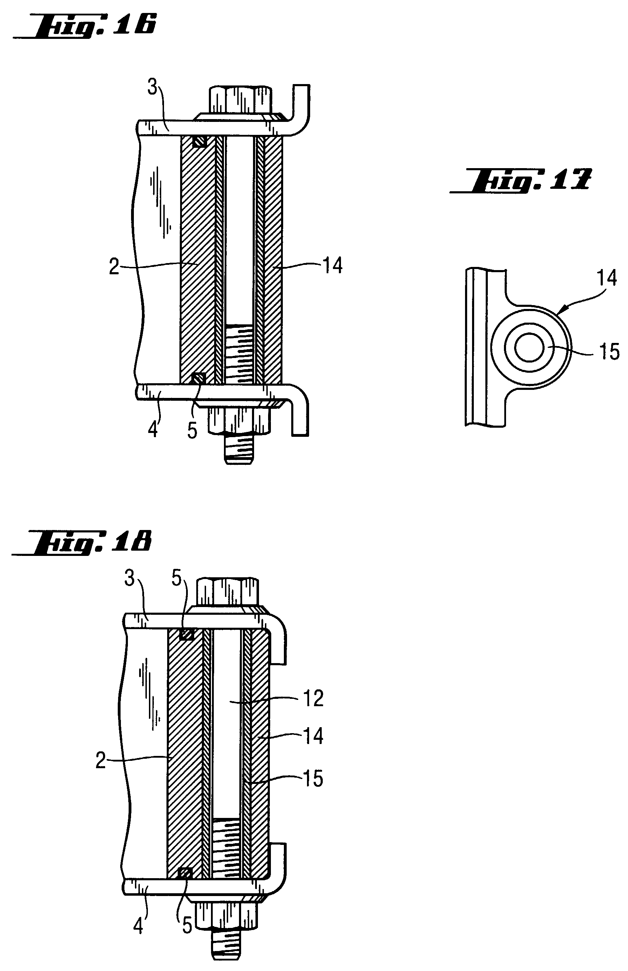

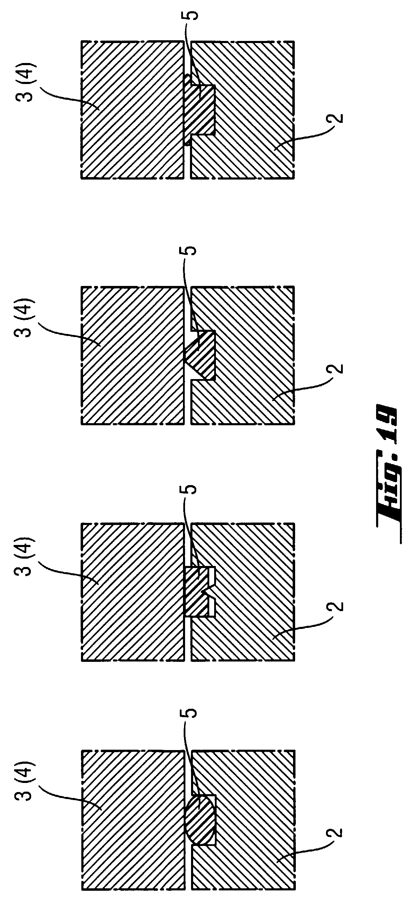

Die Dichtigkeit im Randbereich der Anlage des Deckelteils 3 bzw. 4 an den Rahmen 2 bleibt durch die formsichernden Verstärkungen 8,9 sowie durch Spannelemente 12, die die Deckelteile 3,4 durchgreifen und gegeneinander auf dem Rahmen 2 verspannen, gewährleistet. Die Spannelemente 12 sind als Schraubenbolzen ausgebildet und durchgreifen ebenfalls Durchgangsöffnungen 13 des Rahmens 2, die in daran angeformten Verstärkungsrippen 14 ausgebildet sind und innenseitig Metallhülsen 15 aufweisen. Über die Verstärkungsrippen 14 ist einerseits der Rahmen 2 ausgesteift, zudem bilden diese mit ihren seitlichen Stirnflächen ein Widerlager für die Deckelteile 3,4 aus, so daß auch bei festem Verspannen diese nicht um den Rand des Rahmens 2 gebogen werden können und insofern die Dichtigkeit gewährleistet bleibt. Vorzugsweise sind die Verstärkungsrippen 14 außen auf dem Rahmen 2 angeordnet, um den von diesem umgriffenen Raum nicht einzuschränken. Auch von dem Rahmen beidseits vorstehende Verstärkungsrippen 14 sind möglich (Fig. 14, Fig. 15), ebenso auf der Innenseite befindliche Verstärkungsrippen 14 (Fig. 12, Fig. 13).

Als Kühlmedium 10 findet insbesondere eine niedrig siedende Flüssigkeit Verwendung, deren Siedepunkt beispielsweise bei einem Druck von 1 bar bei etwa 35°C und bei einem Druck von 15 bar bei etwa 120°C liegt. Zur Gewährleistung der Siedebadkühlung steht der Innenraum des Gehäuses 1 über einen Gasaustritt 16 in Verbindung mit einem Kühler, in dem verdampftes Kühlmedium 10 durch Abkühlung kondensiert und wieder dem Gehäuseinnenraum zugeführt wird. Hierfür ist der Gasaustritt 16 einerseits mit einer inneren Gasleitung 17 versehen und andererseits mit einer Kondensatrückleitung 18. Die Kondensatrückleitung 18 umgibt die Gasleitung 17 im Ausführungsbeispiel konzentrisch.

Während des Betriebes ist sicherzustellen, daß nur gasförmige Bestandteile des Kühlmediums 10 aus dem Gehäuse 1 austreten, um eine hinreichende Einbettung der Baugruppe 6 in flüssigem Kühlmedium 10 zu gewährleisten. Hierfür ist im oberen Bereich des Gehäuses 1 eine Gasleitung 19 vorgesehen, die die Gasaustrittsöffnung 16 mit zwei in oberen Eckbereichen des Gehäuses 1 angeordneten Eintrittsöffnungen 20,21 verbindet. Die Eintrittsöffnungen 20,21 führen über Leitungsteile 22 bzw. 23 in einen mittleren oberen Bereich 24 des Gehäuses 1, von dem aus ein weiterer Leitungsteil 25 zur Gasaustrittsöffnung 16 abzweigt. Dabei bilden die Leitungsteile 22,23 jeweils Schlaufen 26,27 aus, die, ausgehend vom mittleren Bereich 24, den jeweils der Eintrittsöffnung 20 bzw. 21 gegenüberliegenden oberen Eckbereich durchlaufen. Durch diese Anordnung der Gasleitung 19 ist gewährleistet, daß auch bei einer extremen Schrägstellung des Gehäuses 1 (Fig. 9), wie es etwa während des Betriebes von Kraftfahrzeugen auftreten kann, nur eine der Eintrittsöffnungen 20,21 überspült wird und die Flüssigkeit 10 einen mittleren Bereich 24 überlaufen kann, ohne daß Flüssigkeit 10 aus dem Gasaustritt 16 das Gehäuse verlassen würde. Die in die Leitungsteile 22,23 eingedrungene Flüssigkeit 10 wird bei Rückstellung der Schräglage durch die jeweilige Öffnung 20,21 größtenteils wieder in das Gehäuse 1 zurückfließen. Der jeweils nicht überspülte Gaseintritt 20,21 kann auch während dieser Schräglage weiterhin über seine Verbindung 26 bzw. 27 mit dem mittleren Bereich 24 und dem hiervon abzweigenden und zur Gasaustrittsöffnung 16 führenden Leitungsteil 25 einen Gasaustausch mit dem Kühler bewirken. Durch die Vermeidung von Flüssigkeitsaustritt aus dem Gehäuse 1 wird der Flüssigkeitspegel auch in Schräglage so hoch gehalten, daß die Baugruppe 6 umspült bleibt und somit auch im oberen Bereich befindliche elektronische Teile eine bestmögliche Kühlung erhalten.

Um einerseits eine Stoß- und Vibrationsentkopplung und andererseits eine Abschirmung gegen elektromagnetische Strahlung sowie eine Wärmeisolierung zu erhalten, ist das Gehäuse 1 insgesamt in einem Außengehäuse 30 über Schwingungsdämpfer 31 hängend gehalten, wobei das Außengehäuse 30 eine Kapselung für das Innengehäuse 1 ausbildet. Das Gehäuse 30 ist zu dem Gehäuse 1 beabstandet, wobei in den Zwischenraum zusätzliche Dämmstoffe zur Wärmeisolierung eingesetzt sein können, beispielsweise Schaumstoffe oder dergleichen, insbesondere in Form von Halbschalen 32,33, die das Gehäuse 1 umgeben.

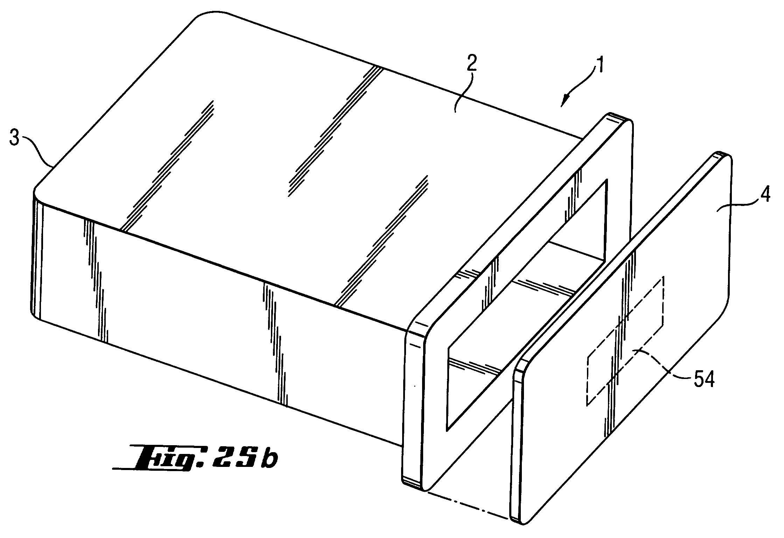

Um eine Schwingungsentkopplung auch im Bereich der elektrischen Durchführungen zu gewährleisten, führt ein elektrisches Kabel nicht unmittelbar durch eine Durchführung einer Wandung 40 des Außengehäuses 30 in das Gehäuse 1, sondern in dem Zwischenraum 44 ist das Anschlußkabel 41 mäandrierend verlegt und sowohl an der Wand 2 des Gehäuses 1 als auch an der Wand 40 des Außengehäuses 30 jeweils festgelegt, wobei durch die Schlaufe 42 in dem im Zwischenraum verlegten Anschlußkabel 41 eine erste Entkopplung ermöglicht ist (Fig. 23). Weiterhin ist die Baugruppe 6 im Innern des Gehäuses 1 nicht direkt mit dem Rahmen 2 oder den Deckelteilen 3,4 in Kontakt, sondern zu dieser beabstandet. Der elektrische Kontakt der Baugruppe 6 wird über flexible Bleche 43 hergestellt, die weitere Schwingungsanteile absorbieren.

Auch bei Anordnung eines derartigen Gehäuses 1 bzw. eines das Gehäuse 1 teilweise oder vollständig umgebenden Außengehäuses 30 nahe einer vibrierenden Verbrennungskraftmaschine ist dadurch eine weitestgehende Schwingungsentkopplung der im Gehäuse 1 befindlichen elektronischen Baugruppe 6 von den Schwingungen der Kraftmaschine oder des Fahrzeugs gewährleistet.

Das Außengehäuse 30 kann eine das Innengehäuse umgebende Kapsel ausbilden, die direkt an die Verbrennungsmaschine angeflanscht ist. Statt eines Außengehäuses 30 ist auch ein nicht vollständig geschlossener Käfig zur Erreichung einer elektromagnetischen Abschirmung möglich.

Um eine Durchführung von Kabeln durch das Außengehäuse 30 zu erleichtern, sind in dem Gehäuse 30 Ausnehmungen 45 vorgesehen, in die Einschubteile 46 einführbar sind, die ihrerseits Kanäle 47 für vorkonfektionierte Kabel aufweisen. Dabei sind die Kabel in den Kanälen 47 bereits vor Montage des Gehäuses 30 verlegt, müssen also nicht bei der Montage durch diese hindurchgeführt werden. Die Einschubteile 46 können in die Ausnehmungen 45 durch einfache Schubbewegung während der Montage eingeführt werden. Eine Halterung der Einschubteile 46 kann dabei über Federn 48, insbesondere Blattfedern, erfolgen. Eines dieser Einschubteile 46 kann über seinen Kanal 47b auch einen Gasdurchgang zur Verfügung stellen.

Um sowohl die Dichtigkeits- als auch die Stabilitätsanforderungen zu erfüllen, besteht das Rahmenteil 2 vorzugsweise aus einem Polyphenylensulfid (PPS), das einen hochfesten Thermoplast darstellt, der im angesprochenen Temperaturintervall unkritisch ist und beständig gegenüber den eingesetzten Kühlmedien. Während der Herstellung dieses Rahmens 2 werden elektrische Verbindungsteile 50, die den Rahmen 2 durchgreifen, in diesen eingegossen, so daß diese dicht in die Kunststoffmasse eingebettet sind. Als Deckelteile 3,4 kommen insbesondere Blechteile in Betracht, die die hohen Drücke (bis ca. 15 bar), die im Kühlmedium 10 entstehen, abfangen können, ohne Schaden zu nehmen, wobei gleichzeitig eine Verformung der mittleren Bereiche 11 zur Volumenvergrößerung möglich ist. Geeignete Kunststoffmaterialien sind grundsätzlich für die Deckelteile 3,4 denkbar.

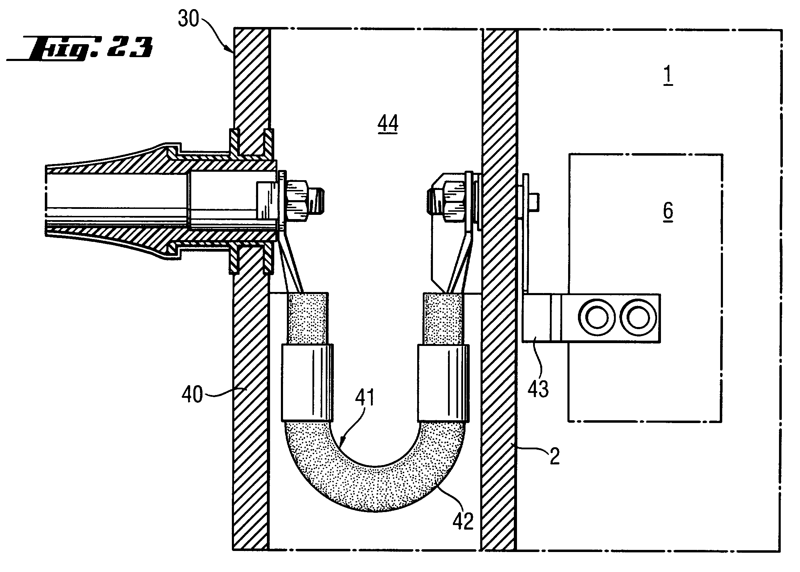

Die Abdichtung zwischen dem Seitenwandteil 2 und einem Abschlußwandteil 3,4 kann über verschiedene Dichtungen 5 erfolgen, beispielsweise eine O-Ring- Schnurdichtung, eine Kontur-Flachdichtung, eine Formdichtung oder eine dauerelastische Vergußmasse (Fig. 19).

Zur Abdichtung zwischen dem Seitenwandteil 2 bzw. dem Abschlußwandteil 3,4, in den die elektrischen Verbindungsteile 50 eingegossen sind, ist vorgesehen, eine Ringnut 51 innenseitig des Gehäuses 1 anzuordnen, die mit Vergußmasse 52 befüllt wird. Dadurch können unterschiedliche Temperaturkoeffizienten des elektrischen Verbindungsteils, der metallisch ausgebildet ist, und der umgebenden Kunststoffmasse, beispielsweise PPS, ausgeglichen werden, ohne daß die Dichtigkeit zwischen diesen Bauteilen beeinträchtigt wäre. Die Vergußmasse 52 ist dauerelastisch, haftet sowohl an Metall wie auch Kunststoff und dichtet den Spalt zuverlässig ab. Bei Anbringung der Vergußmasse 52 auf der dem Innenraum des Gehäuses 1 zugewandten Seite ist sichergestellt, daß bei innen herrschendem Überdruck die Vergußmasse 52 in die Ringnut 51 eingedrückt wird, wodurch die Abdichtungsfunktion weiter verbessert wird. Es ist zusätzlich möglich, eine Abdichtung auch noch auf der Außenseite vorzunehmen. Die Vergußmasse 52 umschließt vorzugsweise das elektrische Verbindungsteil 50 auf seinem gesamten Umfang. Der elektrische Verbinder 50 ist dabei vorzugsweise so angeordnet, daß er nicht allein in den Wandteil 2,3,4 eingegossen ist, sondern außenseitig an den Wandungsteil unmittelbar ein Steckeransatz 53 angegossen ist, der einen möglicherweise abgewinkelten Endteil 50a des elektrischen Verbinders 50 aufnimmt, wodurch auch die Steckverbindung zu weiterführenden Leitungen zuverlässig abgedichtet ist.

Vorzugsweise sind sämtliche Durchführungen für elektrische Verbindungsteile 50 mit einer Vergußmasse 52 zusätzlich abgedichtet.

In der Fig. 25 sind drei prinzipiell mögliche Gehäusearten schematisch dargestellt. Gemäß Fig. 25a ist wie im oben eingehend erläuterten Ausführungsbeispiel der Seitenwandungsteil 2 aus einem Kunststoffmaterial, insbesondere PPS, ausgeführt, die Deckelteile 3,4 können sowohl mit dem Rahmenteil 2 verspannt als auch verschweißt sein. Ein Verschweißen setzt voraus, daß auch die Deckelteile 3,4 aus Kunststoff bestehen. Der Bereich 54 für die Durchführung von elektrischen Verbindungsteilen 50 ist durch gestrichelte Linien angedeutet und befindet sich im Seitenwandungsteil 2.

Gemäß Fig. 25b ist vorgesehen, daß der Seitenwandungsteil 2 aus einem Stranggußteil, insbesondere einem metallischen Stranggußteil, besteht. Dieses kann stirnseitig mit einem ebenfalls metallischen Deckelteil 3 verschweißt sein, anderenends wird die Stirnseite von einem weiteren Deckelteil 4 gebildet, das die Durchführungen 54 für die elektrischen Verbindungsteile 50 enthält. Ein derartiger Deckel 4 wäre wiederum aus einem Kunststoffmaterial gefertigt.

Gemäß Fig. 25c ist vorgesehen, daß der Abschlußwandteil 4 integral mit dem Seitenwandungsteil 2 ausgebildet ist und der so entstandene Behälterraum oberseitig von einem Deckelteil 3 abgeschlossen wird. Der Deckelteil 3 kann wiederum auf verschiedene Arten an dem Seitenwandungsteil 2 befestigt sein, insbesondere kommt bei Ausbildung von Kunststoffteilen auch ein Verschweißen neben dem Verspannen in Frage.

Es ist dem Fachmann überlassen, welche Art von Gehäusen er für welche Einbaubedingungen er wählt, besonders vorteilhaft bleibt jedoch im Hinblichk auf die gute Ausbeulfähigkeit und die hohe Stabilität die Verwendung eines umlaufenden Seitenrahmens 2 aus beispielsweise PPS, der beidseitig mit Deckelteilen 3,4 aus metallischem Material verspannt ist. Eine derartige Verbindung ist zudem zu Wartungs- und Reparaturzwecken wieder lösbar.

## Patentansprüche

1. Gehäuse (1) zur Aufnahme von elektrischen und/oder elektronischen, von einem Kühlmedium (10) umgebenen Bauteilen (6), bestehend aus einem Seitenwandteil (2) und einem oberseitigen und einem unterseitigen Abschlußwandteil (3;4), dadurch gekennzeichnet,
daß der Seitenwandteil (2) und/oder ein Abschlußwandteil (3;4) aus elektrisch isolierendem, gießfähigem Material besteht und in dieses eingegossene elektrische Verbindungsteile (50) umfaßt, wobei der Seitenwandteil (2) und die Abschlußwandteile (3;4) gemeinsam einen mit einem Kühlmittel (10) zur Siedebadkühlung der elektrischen und/oder elektronischen Bauteile befüllbaren Aufnahmeraum druckdicht umschließen.

2. Gehäuse nach Anspruch 1, dadurch gekennzeichnet,
daß der Seitenwandteil (2) als umlaufender Rahmen aus einem elektrisch isolierenden Werkstoff mit darin eingegossenen elektrischen Verbindungsteilen (50) ausgebildet ist, der beidseitig druckdicht von Deckelteilen (3;4) eingespannt ist.

3. Gehäuse nach Anspruch 1 oder 2, dadurch gekennzeichnet,
daß die elektrischen Verbindungsteile (50) zumindest einseitig gegenüber dem sie umgebenden Abschlußwandteil (3;4) oder Seitenwandteil (2) mittels einer zusätzlich eingebrachten Vergußmasse (52) abgedichtet sind.

4. Gehäuse nach Anspruch 3, dadurch gekennzeichnet,
daß zur Aufnahme der Vergußmasse (52) um ein Ende der elektrischen Verbindungsteile (50) eine Ringnut (51) angeordnet ist, die im montierten Zustand der Teile mit der Vergußmasse (52) zumindest bereichsweise angefüllt ist.

5. Gehäuse nach einem der Ansprüche 3 oder 4, dadurch gekennzeichnet,
daß die Vergußmasse (52) aus einem dauerelastischen, an Metall und Kunststoff haltenden, weichen Material gebildet ist.

6. Gehäuse nach einem der Ansprüche 1 bis 5, dadurch gekennzeichnet,
daß der oder die Abschlußwandteil(e) (3;4) im Bereich ihrer Anlage an den Seitenwandteil (2) eine formsichernde Verstärkung (8;9) aufweisen.

7. Gehäuse nach einem der Ansprüche 1 bis 6, dadurch gekennzeichnet,
daß zumindest eines der Abschlußwandteile (3;4) einen elastisch verformbaren Mittelbereich (11) zur Anpassung an eine Druckdifferenz zwischen dem innerhalb und außerhalb des Gehäuses (1) herrschenden Druck aufweist.

8. Gehäuse nach einem der Ansprüche 2 bis 7, dadurch gekennzeichnet,
daß die Deckelteile (3;4) auf dem Rahmen (2) mittels Spannelementen (12) festgelegt sind.

9. Gehäuse nach Anspruch 8, dadurch gekennzeichnet,
daß die Spannelemente (12) als Schraubenbolzen ausgebildet sind und angeformte Durchgangsöffnungen des Rahmens (2) durchgreifen.

10. Gehäuse nach Anspruch 9, dadurch gekennzeichnet,
daß die Durchgangsöffnungen in angeformten Verstärkungsrippen (14) des Rahmens (2) ausgebildet sind und innenseitig Metallbüchsen (15) enthalten.

11. Gehäuse nach einem der Ansprüche 1 bis 7, dadurch gekennzeichnet,
daß der Seitenwandteil (2) mit zumindest einem der Abschlußwandteile (3,4) verschweißt ist.

12. Gehäuse nach einem der Ansprüche 1 bis 11, dadurch gekennzeichnet,
daß das Gehäuse in seinem in Einbaustellung oberen Bereich eine zu einer Austrittsöffnung (16) führende Gasleitung (19) aufweist, die zumindest zwei, oberen Eckbereichen des Gehäuses zugeordnete Eintrittsöffnungen (20;21) aufweist, an die sich Leitungsteile (22;23) anschließen, die in einem mittleren oberen Bereich (24) des Gehäuses (1) miteinander in Verbindung stehen, wobei von dem mittleren Bereich (24) ein weiterer Leitungsteil (25) zur Austrittsöffnung (16) abzweigt.

13. Gehäuse nach Anspruch 12, dadurch gekennzeichnet,
daß die Leitungsteile (22;23) Schlaufen (26;27) ausbilden, die, ausgehend vom mittleren Bereich (24), den jeweils der Eintrittsöffnung (20;21) gegenüberliegenden oberen Eckbereich durchlaufen.

14. Gehäuse nach einem der Ansprüche 1 bis 13, dadurch gekennzeichnet,
daß das Gehäuse (1) in einem eine äußere Kapsel bildenden Außengehäuse (30) angeordnet und darin über Schwingungsdämpfer (31) aufgehängt ist und in einem solchen Abstand zum Außengehäuse (30) angeordnet ist, daß elektrische Anschlußleitungen (41) zur Schwingungsentkopplung in dem zwischen dem Gehäuse (1) und dem Außengehäuse (30) befindlichen Zwischenraum mäanderförmig verlegbar sind.

15. Gehäuse nach einem der Ansprüche 1 bis 14, dadurch gekennzeichnet,
daß das Gehäuse (1) in einem eine äußere Kapsel bildenden Außengehäuse (30) angeordnet ist, das mit Kabeldurchführungen (47) versehene Einschubteile (46) aufweist, die das Kabel umgeben, wobei die Einschubteile (46) in Ausnehmungen (45) von Wandbereichen (40) des Außengehäuses (30) festlegbar sind.

16. Gehäuse nach einem der Ansprüche 1 bis 15, dadurch gekennzeichnet,
daß der Rahmen (2) aus faserverstärktem PPS besteht.

17. Gehäuse nach einem der Ansprüche 1 bis 16, dadurch gekennzeichnet,
daß die Deckelteile (3;4) aus metallischem Material bestehen.

18. Gehäuse nach einem der Ansprüche 2 bis 17, dadurch gekennzeichnet,
daß formsichernde Verstärkungen (8;9) der Deckelteile (3;4) als Sikken ausgebildet sind.

19. Gehäuse nach Anspruch 18, dadurch gekennzeichnet,
daß in zumindest einem Deckelteil (3;4) eine Sicke (9) im oberen Bereich des Gehäuses (1) als nach außen ausgeformte Aufnahmetasche für Kühlmedium (10) ausgebildet ist.

20. Gehäuse nach Anspruch 19, dadurch gekennzeichnet,
daß die Aufnahmetasche (9) unterhalb der Eintrittsöffnungen (20;21) der Gasleitung (19) angeordnet ist.

21. Gehäuse nach einem der Ansprüche 1 bis 20, dadurch gekennzeichnet,
daß es von einer Wärmeisolierung aus zwei Halbschalen (32;33) umgriffen ist.
